Europäisches Patentamt

European Patent Office

Office européen des brevets

(19)

(11) Publication number: **0 164 711 B1**

(12) **EUROPEAN PATENT SPECIFICATION**

(45) Date of publication of patent specification: **11.12.91**  (51) Int. Cl.⁵: **G01R 31/08**

(21) Application number: **85107101.9**

(22) Date of filing: **08.06.85**

(54) Method for detection and location of a fault point on a power transmission line and device for carrying out the method.

(30) Priority: **15.06.84 SE 8403226**

(43) Date of publication of application:
**18.12.85 Bulletin 85/51**

(45) Publication of the grant of the patent:
**11.12.91 Bulletin 91/50**

(84) Designated Contracting States:
**CH DE FR GB IT LI**

(56) References cited:
**EP-A- 0 062 446**    **DE-A- 2 932 929**
**DE-A- 3 235 239**    **DE-B- 2 440 234**
**FR-B- 2 205 670**    **GB-A- 2 036 478**

**IEE Proc. Vol. 113, No. 6 Jun. 1966 pp.
1057-1062**

(73) Proprietor: **ASEA AB**

**S-721 83 Västeras(SE)**

(72) Inventor: **Nimmersjö, Gunnar, Dipl.-Ing.**
**Slagbjörnsgatan 1**
**S-722 42 Västeras(SE)**

(74) Representative: **Boecker, Joachim, Dr.-Ing.**
**Rathenauplatz 2-8**
**W-6000 Frankfurt a.M. 1(DE)**

Rank Xerox (UK) Business Services

## Description

The invention relates to a method for detection and location of a fault point on a power transmission line according to the precharacterising part of claim 1. The invention also relates to a device for carrying out the method. Such a method and device are substantially known from the document Proceedings IEE 1966, "Study of symmetrical and related components through the theory of linear vector spaces", pages 1057 to 1062.

There are several different methods for fault location on a transmission line. One such method is known from the GB-A-2 036 478, in which a method is described according to which a fault point is assumed and, while making simplified assumptions about the parameters of the network, the current and voltage of the fault point are determined. This determination is repeatedly performed until the current and the voltage have the same phase, which means that the fault point has been located.

Another method is described in SE-A-8205235-8 ( corresponding to US-A-4 559 491. This US-patent has been published after the priority date of the present application.) This application describes a fault location on a section of a three-phase power line. After measurement of currents and voltages at one end of the section, the type of fault is first determined and thereafter certain parameters in an equation system are determined. This system describes the relationships between the complex values of the impedance of the section, the source impedances at the remote end and at the near end of the network, as well as measured currents and voltages while eliminating the fault resistance, the pre-fault current, the zero sequence components, etc. The solution of the equation system provides the distance from the end point of the section to the fault point in question.

Certain aspects on the theory of a travelling wave have also been put to use earlier. SE-PS 368,092 (US-A-3,878,460) describes the principle of a directional wave detector. By studying the signs of the current and voltage waves, it can be determined whether there is a fault in the monitoring direction of the relay protection device towards the fault point. If this is the case, the current and voltage waves have opposite signs.

DE-B-24 40 234 discloses a method which is based on known wave guide equations. According to this method there are formed a wave voltage, wave functions, weighting functions, integral functions, differences and products of these for obtaining product polynomials. One or more of these polynomials are then investigated with respect to their sign as a means to determine the direction to the fault from a given location on the line and/or with respect to the absolute value of the polynomials as a means to determine the distance to the fault from said given location on the line. The document also mentions known matrices for model transformation between single-phase and three-phase currents and voltages.

DE-A-3 235 239 describes a method to determine direction and distance from a measuring point to a fault on a transmission line. In the measuring point, measured voltage and current values are digitized and three consecutive digital measuring values in each quarter of a period are stored with the current values being multiplied by the wave impedance prior to storing. Each set of stored values is used to produce travelling waves from the measuring point to the fault point and in the opposite direction. By linear combinations of the travelling wave signals including, as parameters, the wave impedance, the specific line inductance and the transient time of the travelling waves a fault indication signal is obtained the amount of which indicates the distance to the fault and the sign of which the direction to the fault.

EP-A-0 062 446 describes a method to obtain the position of a fault by measuring the time it takes for a transient to travel from the monitoring point to the fault and back again. The apparatus consists of generating means for extracting transient components, and output means for detecting elapsed time.

The invention aims at developing a method for detection and location of a fault point on a power transmission line of the above-mentioned kind which permits a rapid, accurate and reliable fault detection and a determination of the distance to the fault. The invention also aims at developing a device for a carrying out the method.

In order to achieve this aim the invention suggests a method for detection and location of a fault point on a power transmission line according to the introductory part of claim 1, which is characterized by the features of the characterizing part of claim 1.

Further developments of this method are characterized by the features of the additional claims 2 to 6.

A device for carrying out the method is characterized by the features of claim 7.

Further developments of this are characterized by the features of the additional claims 8 to 10.

The invention is based on a model of the transmission line according to the travelling wave theory. At certain definite time intervals, a measurement of the instantaneous values of the currents and the voltages is carried out at the end point of the transmission line, for example at a station. Based on these measured values and with the aid of the travelling wave theory, and by employing the result of the technical

2

development within the field of electronics and the microprocessor field, the invention offers a new solution concept within the relay protection technique, particularly for distance protection devices and fault location devices.

The invention will be described with reference to the accompanying figures.

Figure 1    shows a timetable for waves on a transmission line and examples of control voltages,

Figure 2    also shows a timetable for waves on a transmission line with alternative control voltages,

Figure 3    shows a voltage distribution calculated with the aid of sampled measured current and voltage values $i_o$ and $u_o$, respectively,

Figure 4    shows a grounded network with a voltage connected to phase R,

Figure 5    shows a symmetrical three-phase network,

Figure 6    shows a first embodiment of an analog protection device according to the invention,

Figure 7    shows a second embodiment of an analog protection device according to the invention,

Figure 8    shows an embodiment corresponding to Figure 7 in greater detail.

In summary the invention can be described as follows:

The instantaneous value of current and voltage at the end point of a transmission line is measured, and a certain number of measured values are stored for a certain period of time in a shift register. The shift register is consecutively updated, and the measured values are used to calculate, digitally or analogically, a number of control voltages related to different points along the length of the protected line. The voltage related to the measuring point is designated $u_o$, calculated voltages are designated $u_1, u_2 \ldots u_n$, and the measured current is designated $i_o$. The voltages $u_1, u_2 \ldots u_n$ are calculated with the aid of formulae derived from the travelling wave theory. This theory states that a wave emanating from the measuring point can be designated $u_o^+ = 1/2(u_o + Z \cdot i_o)$ and the wave arriving at the measuring point can be designated $u_o^- = 1/2(u_o - Z \cdot i_o)$, where Z designates the wave impedance. Somewhere along the transmission line, these waves can be designated $u_j^+(t) = D_j u_o^+(t - \tau_j)$ and $u_j^-(t) = u_o^-(t + \tau_j)/D_j$, respectively, where $D_j$ is the ratio of attenuation of the wave and $\tau_j$ is the transit time. If the transmission line is energized and the calculated control voltage $u_j = u_j^+ + u_j^-$ is constantly zero, there is a fault at point j. Normally, a fault is located between two control points. Characteristic of the control voltages at the points on either side of a fault point is that they have different signs. By interpolation an accurate fault localization can be performed. The invention makes use of suitably chosen matrices for transformation of measured currents and voltages so that transport of data in shift registers can be carried out in independent modes.

The theory of travelling waves on transmission lines is described in several text books, inter alia in "Elektricitetslära" by E. Hallén, Uppsala, 1953. The so-called "telegrapher's equation", which is well-known in this connection and the designation of which indicates that the equation was previously used primarily in fields other than power transmission, states that if

u    = the voltage at a point on the transmission line

i    = the current at the same point

x    = the coordinate of length of the transmission line

r    = the resistance per unit of length

l    = the inductance per unit of length

g    = the conductance per unit of length

c    = the capacitance per unit of length

then the following relationships apply:

$$-\frac{\delta u}{\delta x} = ri + l\frac{\delta i}{\delta t} \qquad (1)$$

$$-\frac{\delta i}{\delta x} = gu + c\frac{\delta u}{\delta t} \qquad (2)$$

In the practical application, which will be described here, it can be assumed that the transmission line is distortion-free. This means that

$$rc + gl \qquad (3)$$

which permits a very simple solution of the equation system (1) and (2): With the assumption according to equation (3), the voltage at a point j on the transmission line can be written as

3

$$u_j(t) = u_j^+(t) + u_j^-(t) \qquad (4)$$

where $u_j^+(t)$ is a wave moving in the positive direction of the transmission line and $u_j^-(t)$ is a wave moving in the negative direction.

Further, it is commonly known that the wave velocity

$$v = \sqrt{\frac{1}{lc}} \qquad (5)$$

and that the wave impedance, with the aid of which the current wave can be expressed, is

$$z = \sqrt{\frac{l}{c}} \qquad (6)$$

In the same way as the voltage at a point j on the transmission line, the current at the same point j can be expressed in accordance with equation (4) as

$$i_j = i_j^+ + i_j^- \qquad (7)$$

where the function dependence on t has been omitted for simplicity.

In addition, the following general equations apply

$$i_j^+ = \frac{u_j^+}{z} \qquad (8)$$

$$i_j^- = -\frac{u_j^-}{z} \qquad (9)$$

which enables the equation (4) to be expressed as

$$u_j(t) = 2u_j^+(t) - Zi_j(t) \qquad (10)$$

or

$$u_j(t) = 2u_j^-(t) + Zi_j(t) \qquad (11)$$

When a wave moves along a line, an attenuation of the amplitude takes place. When the wave has moved from x = O to x = $d_j$, it has at the same time been attenuated by a factor

$$D_j = e^{-\frac{rd_j}{z}} \qquad (12)$$

Starting from the wave velocity according to equation (5), the transit time for the wave from x = O to x = $d_j$ will be

$$\tau_j = d_j \sqrt{lc} \qquad (13)$$

The attenuation according to equation (12) and the transit time according to equation (13) permit $u_j^+(t)$ and $u_j^-(t)$ to be written as

$$u_j^+(t) = D_j u_0^+(t - \tau_j) \qquad (14)$$

and

$$u_j^-(t) = \frac{1}{D_j} u_0^-(t + \tau_j) \qquad (15)$$

where $u_0^-$ is the voltage related to the measuring point at the time $t = 0$.

From equations (10) and (11), $u_j^+(t)$ and $u_j^-(t)$ can also be written as

$$u_j^+(t) = 1/2 \, [u_j(t) + Zi_j(t)] \qquad (16)$$

and

$$u_j^-(t) = 1/2 \, [u_j(t) - Zi_j(t)] \qquad (17)$$

With the aid of the measured values of $u_0$ and $i_0$, the voltage at a point at the distance $d_j$ from the measuring point as a function of the time t, i.e., $u_j(t)$, can now be calculated. Parameters in the algorithm for $u_j(t)$ are, besides the time t, the attenuation $D_j$, the transit time $\tau_j$ and the wave impedance Z according to equation (6). The solution is as follows

$$u_j(t) = \frac{D_j}{2} \left[ u_0(t - \tau_j) + Zi_0(t - \tau_j) \right] + \frac{1}{2D_j} \left[ u_0(t + \tau_j) - Zi_0(t + \tau_j) \right] \qquad (18)$$

Further, using equations (14) and (15), the equation (4) can be written as

$$u_j(t) = D_j u_0^+(t - \tau_j) + \frac{1}{D_j} u_0^-(t + \tau_j) \qquad (19)$$

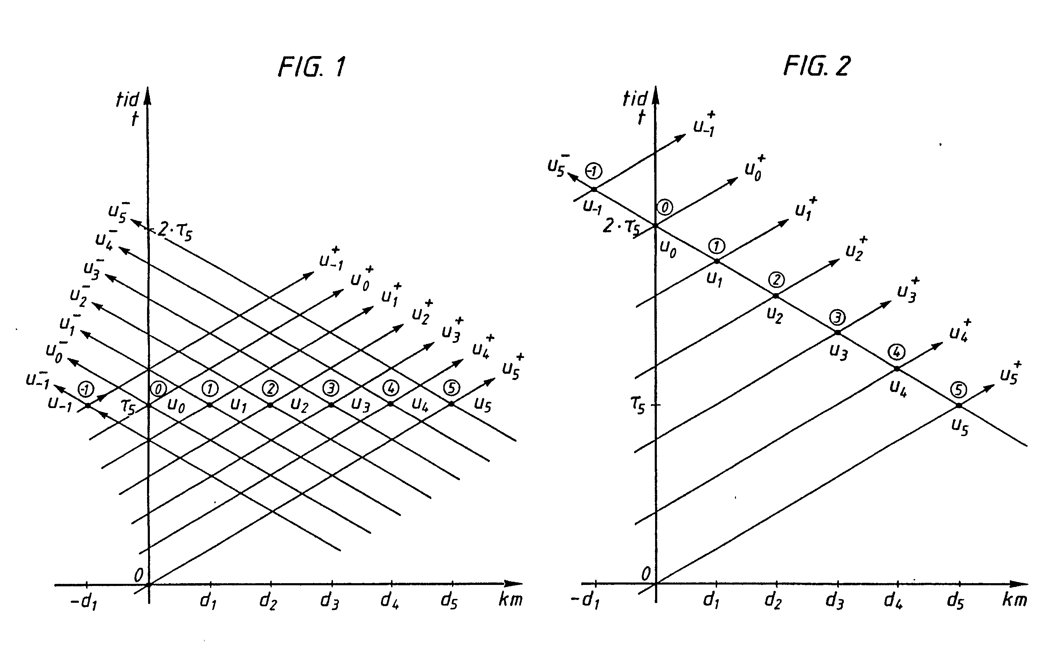

To gain a deeper understanding of the presented theory and thus also of the principle of this invention, we can study Figures 1, 2 and 3. On examining the movement of a wave along a transmission line, a time table can be set up. According to equations (5) and (13), the wave velocity is

$$v = \sqrt{\frac{1}{lc}} = \frac{d_j}{\tau_t}$$

where, as mentioned, $d_j$ is the distance from the measuring point, for example at a station, to a certain point along the transmission line which has been given the serial number j. Since the velocity is constant, the graph for the movement of the wave is a straight line.

In Figure 1 the movement for a plurality of waves has been drawn into a diagram with the distance of the transmission line along the horizontal axis and the time along the vertical axis. The inclination of the line is determined by the wave velocity v.

Starting from time t = O, a number of waves passing the measuring point d = O in the positive direction have been studied. These are $u_5^+$, $u_4^+$, ... $u_0^+$, and $u_{-1}^+$. The time difference between their passage of the measuring point d = O is $\Delta\tau = \tau_1$, where $\tau_2 = 2\Delta\tau$, $\tau_3 = 3\Delta\tau$ and so on. Waves moving in a negative direction, that is $u_{-1}^-$, $u_0^-$, $u_1^-$ ... $u_5^-$, have also been drawn into the diagram.

Since the theory states that the voltage at a point j on the transmission line at a certain moment is the sum of the wave in the positive direction $u_j^+$ and the wave in the negative direction $u_j^-$, at each meeting between a wave with a positive direction of movement and a wave with a negative direction of movement the voltage $u_j$ can be calculated.

Different intersectional points between the $u^+$-waves and the $u^-$-waves may be optionally studied. Figure 1 shows control voltages which are related to the same point of time. In Figure 2 it has been chosen to study control voltages related to a certain wave, $u_5^-$, in the negative direction. Also other alternatives are possible.

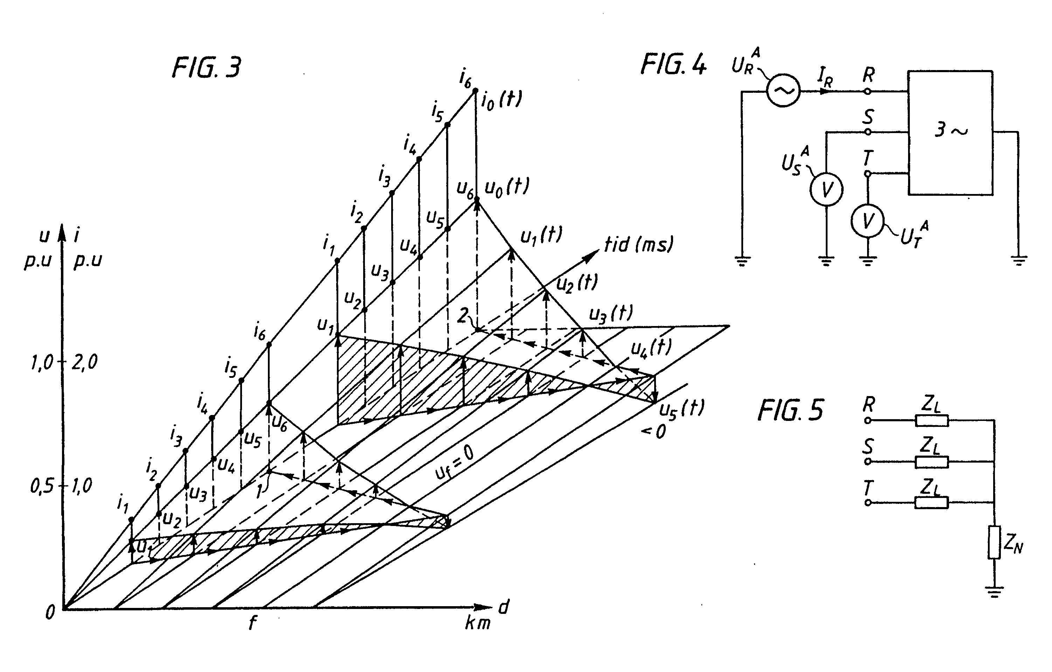

In Figure 1 the calculated voltages $u_{-1}$, $u_0$, $u_1$ ... $u_5$ serve to keep a check on the voltage that prevails at different points along the transmission line at a certain moment. The condition for $u_{-1}$ ... $u_5$ to correspond to actual voltages in the network is that there are no discontinuities between the measuring point O and point j. For j = -1 this condition does not generally apply, since the point O lies at the beginning of the transmission line at a station of some kind. Thus $u_{-1}$ is a fictitious voltage which is used for detection and for distance determination. Several such fictitious voltages could also be conceived, for example $u_{-5}$, which can be used for detecting a fault which lies behind the measuring point of the transmission line. If a fault has occurred between, for example, points 3 and 4, $u_4$ and $u_5$ will also become purely fictitious voltages, which are still included in the pattern constituted by the control voltages and used by the logic unit of the protection device to determine the condition of the transmission line. The task of the fault detection logic unit is to identify the pattern formed by the control voltages during a sequence of times in order to determine whether a fault has occurred and where the fault has occurred Figure 3 indicates that the pattern may vary with time, but the voltage at the fault point f is constantly zero. Also, strictly mathematically it can be shown that the sign of fictitious voltages changes beyond a fault point. When there is a fault point on the transmission line, this will normally lie between two control points, for example between the control points j and j + 1.

The equations stated above apply to single-phase systems. Power lines normally consist of three or possibly more phases. It is well known that a symmetrical multi-phase system can be divided into independent modes. In this way, by suitable transformation, a symmetrical three-phase system can be divided into three single-phase systems which are independent of each other. By applying the previously stated equations to the systems obtained by transformation, the travelling wave model can also be used for calculating the faults for multi-phase systems. For fault analyses and for level sensing, it is often most suitable to use the phase voltages and the main voltages of the original multi-phase system. Therefore, an inverse transformation of the modal control voltages back to the original multi-phase system takes place.

Transformations of these kinds are known from a number of publications of various kinds, for example Proceedings IEE 113 (1966): 6(June) "Study of symmetrical and related components through the theory of linear vector spaces".

Since the utilization of such transformations is included as an integrated part of the method and the device to which this invention relates, a brief summary of the transformation methodology will be described.

Figure 4 shows an arbitrary network with connection terminals R, S and T and a ground connection. If a voltage $U_R^A$ is applied between terminal R and ground, as shown in the figure, a current $I_R$ will flow. This means that we can define the impedance

$$Z_{RR} = \frac{U_R^A}{I_R} \qquad (20)$$

At the same time, as indicated in Figure 4, the voltage $U_S^A$ between terminal S and ground and the voltage $U_T^A$ between terminal T and ground can be measured. This makes it possible to define mutual impedances as

$$Z_{SR} = \frac{U_S^A}{I_R} \qquad (21)$$

$$Z_{TR} = \frac{U_T^A}{I_R} \qquad (22)$$

Now, if the voltage $U_R^A$ is removed and a voltage $U_S^B$ isapplied between terminal S and ground, this gives rise to a current $I_S$, and in a corresponding manner a current $I_T$ will flow when a voltage $U_T^C$ is applied between terminal T and ground. In the same way as for the phase R, the impedances for the phases S and T can now be defined:

$$Z_{SS} = \frac{U_S^B}{I_S} \qquad Z_{TS} = \frac{U_T^B}{I_S} \qquad Z_{RS} = \frac{U_R^B}{I_S}$$

$$Z_{TT} = \frac{U_T^C}{I_T} \qquad Z_{RT} = \frac{U_R^C}{I_T} \qquad Z_{ST} = \frac{U_S^C}{I_T} \qquad (23)$$

Now, if it is assumed that the currents $I_R$, $I_S$ and $I_T$ are simultaneously applied to the respective terminals, according to the superposition theorem the following phase voltages are obtained:

$$U_R = U_R^A + U_R^B + U_R^C$$

$$U_S = U_S^A + U_S^B + U_S^C \qquad (24)$$

$$U_T = U_T^A + U_T^B + U_T^C$$

By introducing the above-mentioned impedances, the equation system describing the network can be written as:

$$U_R = Z_{RR}I_R + Z_{RS}I_S + Z_{RT}I_T$$

$$U_S = Z_{SR}I_R + Z_{SS}I_S + Z_{ST}I_T \qquad (25)$$

$$U_T = Z_{TR}I_R + Z_{TS}I_S + Z_{TT}I_T$$

which in the matrix form can be written as

$$\begin{pmatrix} U_R \\ U_S \\ U_T \end{pmatrix} = \begin{pmatrix} Z_{RR} & Z_{RS} & Z_{RT} \\ Z_{SR} & Z_{SS} & Z_{ST} \\ Z_{TR} & Z_{TS} & Z_{TT} \end{pmatrix} \times \begin{pmatrix} I_R \\ I_S \\ I_T \end{pmatrix} \qquad (26)$$

or in reduced form

$$U_{RST} = Z_{RST} \times I_{RST} \qquad (27)$$

The equation system according to the above can, of course, be solved in conventional manner. In the same way as - in other technical fields - the calculations can be simplified by transformation of equation systems, for example, by Laplace transformation, from a time plane to a frequency plane, also in this case currents and voltages can be transformed so that, on certain conditions, simpler calculations and increased clarity can be achieved.

The transformation of the equation system (25) to modal or independent form implies that we are seeking an equation system

$$U_a = Z_a \times I_a$$

$$U_b = Z_b \times I_b \qquad (28)$$

$$U_c = Z_c \times I_c$$

where it should be possible to express the parameters included in this system with the aid of the parameters in equation system (25). If such a transformation can be made, we will have obtained three systems which are independent of each other so that the movements of the respective shift registers can be made separately. The conditions and the method for performing such a transformation will be clear from the following:

Let it first be assumed that $I_R$, $I_S$ and $I_T$ are replaced by a linear combination of three currents $I_a$, $I_b$ and $I_c$ which fulfill the following relationships

$$I_R = k_{Ra}I_a + k_{Rb}I_b + k_{Rc}I_c$$

$$I_S = k_{Sa}I_a + k_{Sb}I_b + k_{Sc}I_c \qquad (29)$$

$$I_T = k_{Ta}I_a + k_{Tb}I_b + k_{Tc}I_c$$

and in the matrix form it can be written as

$$\begin{pmatrix} I_R \\ I_S \\ I_T \end{pmatrix} = \begin{pmatrix} k_{Ra} & k_{Rb} & k_{Rc} \\ k_{Sa} & k_{Sb} & k_{Sc} \\ k_{Ta} & k_{Tb} & k_{Tc} \end{pmatrix} \times \begin{pmatrix} I_a \\ I_b \\ I_c \end{pmatrix} \qquad (30)$$

or in reduced form

$$I_{RST} = K_{abc} \times I_{abc} \qquad (31)$$

The same method can be applied to the voltages $U_R$, $U_S$ and $U_T$ and in the matrix form there will be the following:

$$\begin{pmatrix} U_R \\ U_S \\ U_T \end{pmatrix} = \begin{pmatrix} 1_{Ra} & 1_{Rb} & 1_{Rc} \\ 1_{Sa} & 1_{Sb} & 1_{Sc} \\ 1_{Ta} & 1_{Tb} & 1_{Tc} \end{pmatrix} \times \begin{pmatrix} U_a \\ U_b \\ U_c \end{pmatrix} \qquad (32)$$

or

$$U_{RST} = L_{abc} \times U_{abc} \qquad (33)$$

Equation systems (30) and (32) must have a solution. With matrix designations this means that there must be an inverse matrix $(K_{abc})^{-1}$ so that

$$I_{abc} = (K_{abc})^{-1} \times I_{RST} \qquad (34)$$

and

$$U_{abc} = (L_{abc})^{-1} \times U_{RST} \qquad (35)$$

where the condition is that

$$(K_{abc})^{-1} \times (K_{abc}) = E$$

and

$$(L_{abc})^{-1} \times (L_{abc}) = E$$

where E is a unit matrix.

Now, using equations (31) and (33) in equations (27), the result will be:

$$(L_{abc}) \times U_{abc} = Z_{RST} \times (K_{abc}) \times I_{abc} \qquad (36)$$

Multiplying both sides by $(L_{abc})^{-1}$ gives

$$U_{abc} = (L_{abc})^{-1} \times Z_{RST} (K_{abc}) \times I_{abc} \qquad (37)$$

By assuming

$$M = (L_{abc})^{-1} \times Z_{RST} \times (K_{abc}) \qquad (38)$$

it is obtained

$$U_{abc} = M \times I_{abc} \qquad (39)$$

On condition that M is given in the form of a diagonal matrix, that is, a matrix of the form

$$M = \begin{pmatrix} Z_a & 0 & 0 \\ 0 & Z_b & 0 \\ 0 & 0 & Z_c \end{pmatrix} \qquad (40)$$

the equation system (39) can be written as

$$U_a = Z_a \times I_a$$

$$U_b = Z_x \times L_b$$

$$U_c = Z_c \times I_c$$

which is the desired equation system (28); thus, three systems independent of each other are obtained.

With knowledge of $Z_a$, $Z_b$ and $Z_c$, the network according to Figure 4 can be entirely controlled, and the voltages $U_a$, $U_b$ and $U_c$ and currents $I_a$, $I_b$ and $I_c$ can be calculated.

Starting from a symmetrical three-phase system, it can be shown that

$K = L$ and

$K^{-1} = L^{-1}$, respectively,

that is,

$$K \times K^{-1} = K \times L^{-1} = K^{-1} \times L = L \times L^{-1} = E$$

The matrices which are used in this connection are the so-called Clarke's matrices which, if our earlier matrix designations are maintained, are constituted by

$$(L_{abc})^{-1} = \begin{pmatrix} \dfrac{1}{\sqrt{3}} & \dfrac{1}{\sqrt{3}} & \dfrac{1}{\sqrt{3}} \\ \sqrt{\dfrac{4}{6}} & -\dfrac{1}{\sqrt{6}} & -\dfrac{1}{\sqrt{6}} \\ 0 & \dfrac{1}{\sqrt{2}} & -\dfrac{1}{\sqrt{2}} \end{pmatrix} \qquad (41)$$

$$K_{abc} = \begin{pmatrix} \dfrac{1}{\sqrt{3}} & \sqrt{\dfrac{2}{3}} & 0 \\ \dfrac{1}{\sqrt{3}} & -\dfrac{1}{\sqrt{6}} & \dfrac{1}{\sqrt{2}} \\ \dfrac{1}{\sqrt{3}} & -\dfrac{1}{\sqrt{6}} & -\dfrac{1}{\sqrt{2}} \end{pmatrix} \qquad (42)$$

In a symmetrical three-phase network, equation systems (26) can be written as

$$
\begin{pmatrix} U_R \\ U_S \\ U_T \end{pmatrix} = \begin{pmatrix} Z_1 & Z_2 & Z_3 \\ Z_3 & Z_1 & Z_2 \\ Z_2 & Z_3 & Z_1 \end{pmatrix} \times \begin{pmatrix} I_R \\ I_S \\ I_T \end{pmatrix} \qquad (43)
$$

Equation (38) can also be written as

$$M = N \times (K_{abc}) \qquad (44)$$

that is,

$$N = (L_{abc})^{-1} \times Z_{RST} \qquad (45)$$

With $(L_{abc})^{-1}$ according to equation (41) and $Z_{RST}$ according to equation (43), the following is obtained

$$
N = \begin{pmatrix} \frac{1}{\sqrt{3}}(Z_1+Z_3+Z_2) & \frac{1}{\sqrt{3}}(Z_2+Z_1+Z_3) & \frac{1}{\sqrt{3}}(Z_3+Z_2+Z_1) \\ \frac{2}{\sqrt{6}}Z_3-\frac{1}{\sqrt{6}}(Z_3+Z_2) & \frac{2}{\sqrt{6}}Z_2-\frac{1}{\sqrt{6}}(Z_1+Z_3) & \frac{2}{\sqrt{6}}Z_3-\frac{1}{\sqrt{6}}(Z_2+Z_1) \\ \frac{1}{\sqrt{2}}(Z_3-Z_2) & \frac{1}{\sqrt{2}}(Z_1-Z_3) & \frac{1}{\sqrt{2}}(Z_2-Z_1) \end{pmatrix} \qquad (46)
$$

Now, in order for

$$
M = N \times (K_{abc}) = \begin{pmatrix} Z_a & 0 & 0 \\ 0 & Z_b & 0 \\ 0 & 0 & Z_c \end{pmatrix} \qquad (47)
$$

then it is presupposed that

$$Z_2 = Z_3 \qquad (48)$$

which, after certain intermediate calculations, gives

$$Z_a = Z_1 + 2Z_2$$

$$Z_b = Z_1 - Z_2 \qquad (49)$$

$$Z_c = Z_1 - Z_2$$

Now, looking at a network according to Figure 5, it can be seen that

$$Z_1 = Z_L + Z_N \qquad (50)$$

$$Z_2 = Z_3 + Z_N \qquad (51)$$

that is, after intermediate calculations

$$Z_a = Z_L + 3Z_N$$

$$Z_b = Z_L \qquad (52)$$

$$Z_c = Z_L$$

Since $U_R$, $U_S$ and $U_T$ are known by measurement, there is the possibility of calculating, with the aid of equation (35), the transformed voltage vector $U_0'$ as $U_a$, $U_b$ and $U_c$, that is,

$$U_0' = \begin{pmatrix} U_a \\ U_b \\ U_c \end{pmatrix} = (L_{abc})^{-1} \begin{pmatrix} U_{RO} \\ U_{SO} \\ U_{TO} \end{pmatrix} \qquad (53)$$

With knowledge of $U_a$, $U_b$ and $U_c$ as well as $Z_a$, $Z_b$ and $Z_c$, it is now possible to calculate $I_a$, $I_b$ and $I_c$ with the aid of $I_{RO}$, $I_{SO}$ and $I_{TO}$. When calculating in the respective independent a-, b- and c-systems, the parameters attenuation, transit time, and wave impedance will be designated $D_{ja}$, $\tau_{ja}$, $Z_a$, $D_{jb}$, $\tau_{jb}$, $Z_b$ and $D_{jc}$, $\tau_{jc}$ and $Z_c$, respectively. Phase quantities at the control point can be obtained again by transformation by K (or L), that is

$$U_j = KU_j' = \begin{pmatrix} U_{jR} \\ U_{jS} \\ U_{jT} \end{pmatrix} \qquad (54)$$

It is the phase quantities that are most suitable to study. Single-phase faults are indicated by using $U_{jR}$, $U_{jS}$ and $U_{jT}$ individually, which also makes it possible to make phase selections for single-phase tripping. For other types of fault, the respective main voltages are used, that is, $U_{jR} - U_{jS}$, $U_{jS} - U_{jT}$ and $U_{jT} - U_{jR}$.

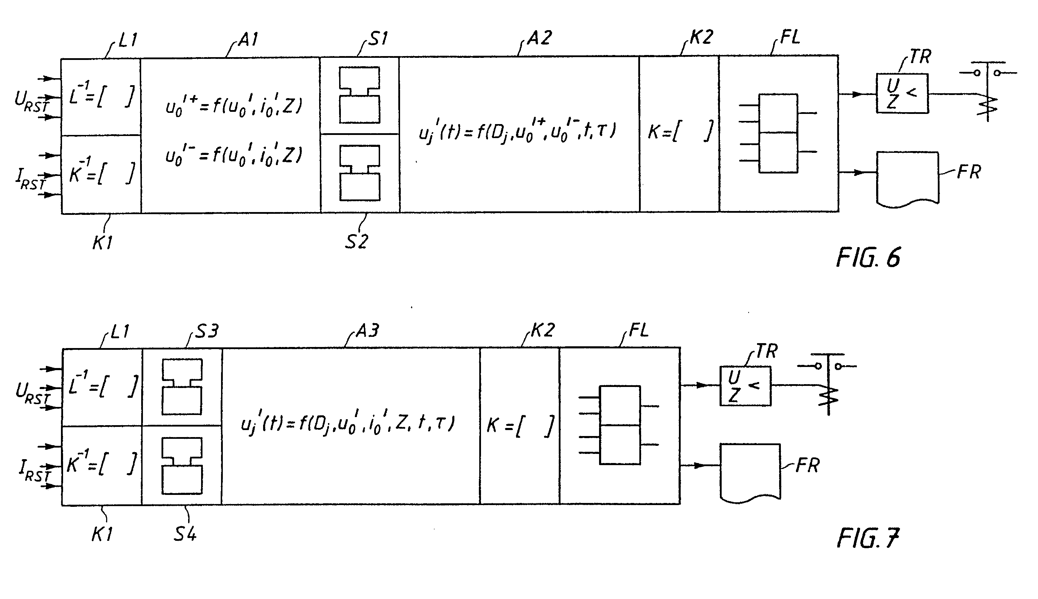

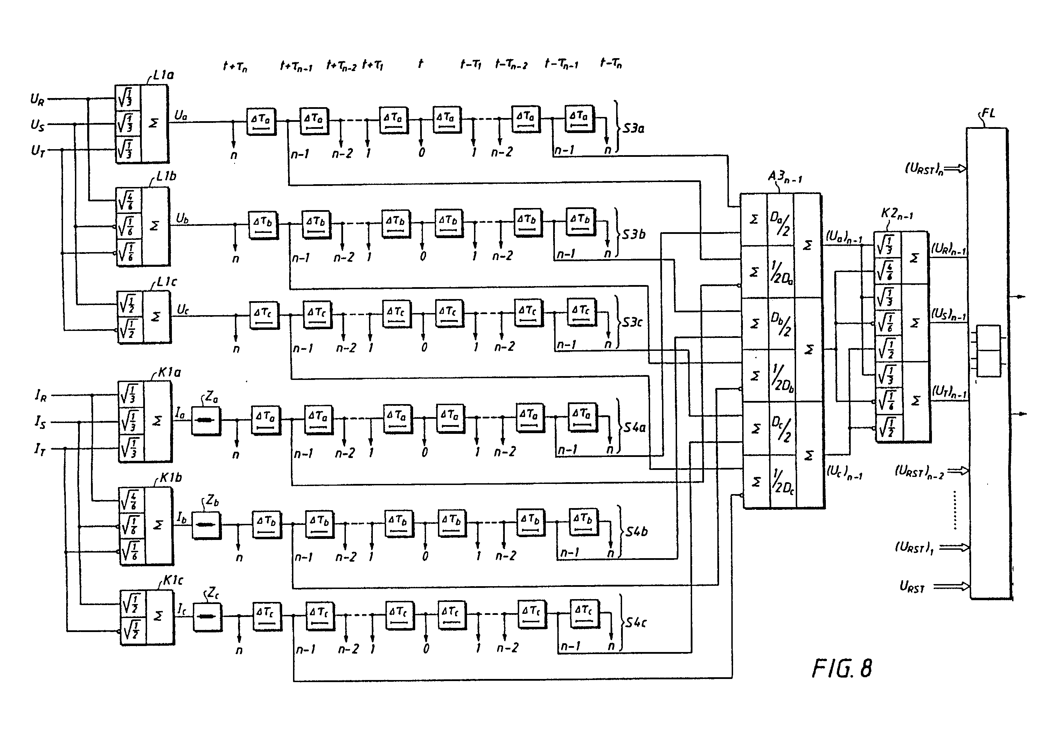

The protection device for carrying out the method according to the invention can be built up in analog or digital technique. Examples of embodiments in analog technique are shown in Figures 6 and 7.

In an embodiment according to Figure 6, transformation of incoming phase voltages $U_{RST}$ and phase currents $I_{RST}$ into modal transformed quantities is carried out in the transformation units L1 and K1 with the matrices $L^{-1}$ and $K^{-1}$, respectively. In this embodiment a calculation is first carried out in the calculating unit A1 of

$$U'_O{}^+ = 1/2(U'_O + Z \cdot I'_O) \text{ and} \quad (55)$$

$$U'_O = 1/2(U'_O - Z \cdot I_O'), \text{ respectively,} \quad (56)$$

which values are consecutively stored and updated in the shift registers S1 and S2. A shift register is present for each mode and each wave type, that is, both for voltage waves and current waves. In calculating unit A2 a calculation of uj'(t) in accordance with equation (19) takes place. The values of the modal voltages $U_a$ / $U_b$ / $U_c$ at the selected points, thus obtained, are transformed in transformation unit $K_2$, corresponding to the previously described matrix K, back to phase voltages $U_R$, $U_S$ and $U_T$. These values for each selected point are then supplied to the fault detection logic unit FL for evaluation. From this unit a possible order for tripping via $T_R$ and printout of a fault report via FR is given.

Figure 7 is an embodiment showing the same units L1, K1, K2, FL, TR and FR as in Figure 6. In the shift registers S3 and S4 the transformed values of $U_O$ and $I_O$ and possibly $I_O \cdot Z$ are conceived to be stored. In the calculating unit A3 the voltages $U_a$, $U_b$ and $U_c$ at the selected points are now calculated in accordance with equation (18).

Figure 8 illustrates a more detailed block diagram corresponding to Figure 7. Transformation of incoming phase voltages $U_{RST}$ and phase currents $I_{RST}$ to modal transformed voltages $U_a$, $U_b$ and $U_c$ and currents $I_a$, $I_b$ and $I_c$ takes place in the matrix units L1a, L1b, L1c and in K1a, K1b, K1c, respectively. As will be clear from Figure 8 only summing operational amplifiers are required for both the matrix treatment and the other calculations.

The modal voltage values are each supplied to a respective shift register S3a, S3b and S3c, and the modal current values are multiplied by the respective modal impedances, whereafter the voltage values are obtained and then supplied to shift registers S4a, S4b and S4c.

If it is assumed that control voltages at n points along the transmission line are to be calculated, the shift register has to be able to store 2n measured values in each mode, corresponding to measurements at times $t - \tau_n$, $t - \tau_{n-1}$ ... $t - \tau_1$, $t$, $t + \tau_1$ ... $t + \tau_{n+1}$, $t + \tau_n$. The stored values, related to a certain time t, are now used to calculate the control voltages at this time and the calculations take place according to equation (18). Figure 8 shows how the calculation at point n-1 may be performed. The calculation part $A3_{n-1}$ is thus that part of A3 in Figure 7 which calculates the voltage at point n-1. Corresponding calculation parts exist for each control point. These parts are supplied with input values in the same way as $A3_{n-1}$ from the arrows at n, n-2, etc., shown in the figure.

The calculation part $A3_{n-1}$ gives measured values corresponding to $(U_a)_{n-1}$, $(U_b)_{n-1}$ and $(U_c)_{n-1}$. The corresponding $U_{abc}$ values for the other control points are also available now. As mentioned before, however, it is more appropriate for the fault estimate to change over to the phase quantities in question. This is done, as previously described, by inverse transformation of the calculated control voltages. In Figure 8 this inverse transformation is described for the control voltages $(U_a)_{n-1}$, $(U_b)_{n-1}$ and $(U_c)_{n-1}$ with the transformation module $K2_{n-1}$, corresponding to the previously described matrix according to equation (42). Also in this case, the transformation can be carried out by using summing amplifiers only. After the transformation, the control voltage at point n-1 is accessible in the form of respective phase voltages $(U_R)_{n-1}$, $(U_S)_{n-1}$ and $(U_T)_{n-1}$.

The calculated voltages $U_a$, $U_b$ and $U_c$ for the other control points are transformed in matrix blocks corresponding to $K2_{n-1}$ into phase quantities (not shown), which means that the fault detection logic unit FL has access to all the phase voltages at all the control points.

If the control voltages at two consecutive points j and k, that is, uj(t) and uk(t), constantly have different signs, the conclusion can be drawn that there is a fault between j and k. It is obvious that it is desired to keep the number of control points as low as possible. Problems with the fault location may then arise in those cases where a fault lies near j and when uj is near zero. A suitable comparison method is the following

$$u_{j-1} \longleftrightarrow u_j$$

$$u_{j-1} \longleftrightarrow u_k$$

$$u_j \longleftrightarrow u_k$$

$$u_j \longleftrightarrow u_{k+1}$$

In order quickly to obtain a fault indication, the values of the voltages $u_{-1}$, $u_0$ and $u_n$ are of great importance.

If the fault location logic has determined that two consecutive control points j and k are respectively situated on either side of a fault, the value of the control voltages $u_j$ and $u_k$ can be utilized for determining the position of the fault point. If the point j lies at the distance $d_j$ from the measuring station, and if the distance between the control points is $\delta(k-j)$, the formula for calculating the distance from the measuring station to the fault point $d_f$ will be equal to:

$$d_f = d_j + \frac{\delta(k-j)\, u_j}{u_j - u_k} \tag{57}$$

This is an interpolation method, and for greater accuracy other interpolation methods may be used.

If the source impedance is smaller than the line impedance, the current at the measuring point will be greater in case of a near-end line fault than in case of a busbar fault which is behind the measuring point. The result is that the calculated voltage $u_n$ will be greater in amount in case of a near-end fault, whereas in case of a busbar fault $u_n$ can never be greater than the operating voltage.

The voltage

$$u_n = 1/2\left[D_n Z i_0(t - \tau_n) - \frac{1}{D_n} Z i_0(t + \tau_n)\right]$$

can be approximated to

$$u_n = Z/2\left[i_0(t - \tau_n) - i_0(t + \tau_n)\right]$$

Thus, the value of voltage $u_n$ will be greater if the current change is larger.

In the foregoing, only the methods for the fault location logic have been described. Devices for carrying out the method can be constructed in many different ways which, however, with the knowledge displayed above are trivial and known per se and therefore not described in this specification.

This distance measuring relay protection device, which has been described above, can be supplemented with a directional wave detector.

## Claims

1. Method for detection and location of a fault point on a power transmission line included in a single-phase, three-phase or multi-phase distribution system energized from a power network system at normal mains frequency, whereby the instantaneous values of the current and the voltage are measured in each phase at the end point of the transmission line and the measured values are stored in a shift register, **characterized** in that control voltages

$u_1(t)$, $u_2(t)$, ... $u_j(t)$, ... $u_n(t)$ at a number of control points (1, 2, ... j, ... n) along the transmission line are calculated as a time series for each control point by means of a formula, derived from travelling wave theory according to

$$u_j(t) = \frac{D_j}{2}\left[u_O(t-\tau_j) + Zi_O(t-\tau_j)\right] + \frac{1}{2D_j}\left[u_O(t+\tau_j) - Zi_O(t+\tau_j)\right]$$

where

$D_j$ = attenuation factor of the travelling wave from control point j,

$\tau_j$ = transit time of the travelling wave from control point j,

$u_o$ = voltage at end point of the transmission line,

$i_o$ = current at end point of the transmission line,

$Z$ = wave impedance

that the calculated control voltages along the transmission line and their conceived extension at the two end points are used for detecting and locating a fault point on the transmission line, that a fault is determined if the control voltages at two consecutive control points constantly have different signs this fault being located on the transmission line between said two points, that the exact location of the fault on the transmission line is determined as that point on the transmission line where the control voltage is constantly zero, this fault point (f) being obtained by an interpolation method.

2. Method according to claim 1, **characterized** in that the distance $d_f$ from the measuring station to the fault is calculated as

$$d_f = d_j + \frac{\delta(k-j)\ u_j}{u_j - u_k}$$

where $d_j$ is the distance from the measuring station to the control point j, $\delta$ (k-j) is the distance between the control points k and j, and $u_j$ and $u_k$ are the control voltages at the control points j and k.

3. Method according to claim 1, **characterized** in that in the calculations of the control voltages there are used measured current and voltage values at the times $t + \tau_k$ and $t - \tau_k$, where $\tau_k$ is the transit time of a wave on the transmission line from the measuring point to the control point k, with k running from O to n.

4. Method according to any of the preceding claims, **characterized** in that for three-phase and multi-phase systems, the measured current and voltage values are transformed to independent modal values, which are used when calculating the control voltages in accordance with the formula stated in claim 1.

5. Method according to any of the preceding claims, **characterized** in that the modally calculated voltages are returned by inverse transformation to their respective original systems.

6. Method according to any of the preceding claims, **characterized** in that the method is used for distance protection by supplementing the distance-measuring protection device with a directional wave detector of known type.

7. Device for detection and location of a fault point on a power transmission line included in a single-phase, three-phase or multi-phase distribution system energized from a power network system at normal mains frequency, the device comprising modal transformation units (L1, K1), control voltage calculators (A2,A3), shift registers (S1, S2, S3, S4), inverse modal transformation units (K2) and a fault logic unit (FL) and having access to current and voltage values at the end of the transmission line, **characterized** in that the modal transformation units (L1, K1) are arranged to transform measured current and voltage values to modal values, that means are provided to consecutively supply said transformed values to said shift registers (S3, S4) and from there to the calculating units (A3) for calculation of control voltages according to the formula

$$u_j(t) = \frac{D_j}{2}\left[u_0(t-\tau_j) + Zi_0(t-\tau_j)\right] + \frac{1}{2D_j}\left[u_0(t+\tau_j) - Zi_0(t+\tau_j)\right]$$

where

$D_j$ = attenuation factor of the travelling wave from control point j,
$\tau_j$ = transit time of the travelling wave from control point j,
$u_0$ = voltage at end point of the transmission line,
$i_0$ = current at end point of the transmission line,
$Z$ = wave impedance

that the units for inverse transformation (K2) are arranged to transform the calculated control voltages to corresponding values in the original systems, and that means are provided to supply these values to the fault logic unit (FL) for determining whether a fault exists and for calculating the distance to the fault from the measuring point.

8. Device according to claim 7, **characterized** in that the fault logic unit is constructed in analog technique.

9. Device according to claim 7, **characterized** in that the fault detection logic unit is constructed in digital technique.

10. Device according to any of claim 7 to 9, **characterized** in that the distance-measuring protection device is supplemented with a directional wave detector of known type, thus together forming a distance protection device.

**Revendications**

1. Procédé de détection et de localisation d'un point de défaut sur une ligne de transport d'énergie qui est incorporée dans un système de distribution monophasé, triphasé ou polyphasé, alimenté à partir d'un réseau d'énergie électrique à la fréquence normale du secteur, dans lequel on mesure les valeurs instantanées du courant et de la tension dans chaque phase à l'extrémité de la ligne de transport, et on enregistre les valeurs mesurées dans un registre à décalage, **caractérisé** en ce qu'on calcule des tensions de commande $u_1(t)$, $u_2(t)$, ..., $u_j(t)$, ..., $u_n(t)$ en un certain nombre de points de commande (1, 2, ... j, ... n) le long de la ligne de transport, sous la forme d'une série temporelle pour chaque point de commande, au moyen d'une formule qui est établie sur la base de la théorie des ondes progressives, et qui est la suivante :

$$u_j(t) = \frac{D_j}{2}\left[u_0(t-\tau_j) + Zi_0(t-\tau_j)\right] + \frac{1}{2D_j}\left[u_0(t+\tau_j) - Zi_0(t+\tau_j)\right]$$

avec les notations :

$D_j$ = facteur d'atténuation de l'onde progressive à partir du point de commande j,
$\tau_j$ = temps de transit de l'onde progressive à partir du point de commande j,
$u_0$ = tension à l'extrémité de la ligne de transport,
$i_0$ = courant à l'extrémité de la ligne de transport,
$Z$ = impédance d'onde,

en ce qu'on utilise les tensions de commande calculées le long de la ligne de transport et leur extrapolation aux deux extrémités, pour détecter et localiser un point de défaut sur la ligne de transport, en ce qu'on détermine l'existence d'un défaut si les tensions de commande à deux points de

EP 0 164 711 B1

commande consécutifs ont constamment des signes différents, ce défaut se trouvant sur la ligne de transport entre les deux points précités, en ce qu'on détermine la position exacte du défaut sur la ligne de transport comme étant le point sur la ligne de transport auquel la tension de commande est constamment égale à zéro, ce point de défaut (f) étant obtenu par un procédé d'interpolation.

2. Procédé selon la revendication 1, **caractérisé** en ce qu'on calcule la distance $d_f$ de la station de mesure jusqu'au défaut par la formule :

$$d_f = d_j + \frac{\delta(k-j)\ u_j}{u_j - u_k}$$

dans laquelle $d_j$ est la distance de la station de mesure jusqu'au point de commande j, $\delta(k-j)$ est la distance entre les points de commande k et j, et $u_j$ et $u_k$ sont les tensions de commande aux points de commande j et k.

3. Procédé selon la revendication 1, **caractérisé** en ce que dans les calculs des tensions de commande, on utilise des valeurs de courant et de tension mesurées aux instants $t + \tau_k$ et $t - \tau_k$, en désignant par $\tau_k$ le temps de transit d'une onde sur la ligne de transport, du point de mesure jusqu'au point de commande k, avec k variant de 0 à n.

4. Procédé selon l'une quelconque des revendications précédentes, **caractérisé** en ce que pour des systèmes triphasés et polyphasés, on transforme les valeurs de courant et de tension mesurées en valeurs modales indépendantes, que l'on utilise au moment du calcul des tensions de commande conformément à la formule qui est indiquée dans la revendication 1.

5. Procédé selon l'une quelconque des revendications précédentes, **caractérisé** en ce qu'on retourne des tensions calculées par la méthode modale, à leurs systèmes d'origine respectifs, par transformation inverse.

6. Procédé selon l'une quelconque des revendications précédentes, **caractérisé** en ce qu'on utilise ce procédé pour la protection de distance en adjoignant au dispositif de protection par mesure de distance, un détecteur d'onde directionnel de type connu.

7. Dispositif de détection et de localisation d'un point de défaut sur une ligne de transport d'énergie qui fait partie d'un système de distribution monophasé, triphasé ou polyphasé, alimenté à partir d'un réseau d'énergie électrique à la fréquence normale du secteur, le dispositif comprenant des unités de transformation modale (L1, K1), des calculateurs de tension de commande (A2, A3), des registres à décalage (S1, S2, S3, S4), des unités de transformation modale inverse (K2) et une unité logique de détection de défaut (FL) et ayant accès à des valeurs de courant et de tension à l'extrémité de la ligne de transport, **caractérisé** en ce que les unités de transformation modale (L1, K1) sont conçues pour transformer en valeurs modales des valeurs de courant et de tension mesurées, en ce que des moyens sont incorporés pour appliquer consécutivement les valeurs transformées aux registres à décalage (S3, S4), et à partir de là aux unités de calcul (A3), pour le calcul de tensions de commande conformément à la formule :

$$u_j(t) = \frac{D_j}{2}[u_0(t-\tau_j) + zi(t-\tau_j)] + \frac{1}{2D_j}[u_0(t+\tau_j) - zi_0(t+\tau_j)]$$

dans laquelle

$D_j$ = facteur d'atténuation de l'onde progressive à partir du point de commande j,

$\tau_j$ = temps de transit de l'onde progressive à partir du point de commande j,

17

$u_0$ = tension à l'extrémité de la ligne de transport,

$i_0$ = courant à l'extrémité de la ligne de transport,

Z = impédance d'onde,

en ce que les unités de transformation inverse (K2) sont conçues de façon à transformer les tensions de commande calculées en valeurs correspondantes dans les systèmes d'origine, et en ce que des moyens sont incorporés pour appliquer ces valeurs à l'unité logique de détection de défaut (FL), pour déterminer si un défaut existe et pour calculer la distance du point de mesure jusqu'au défaut.

8. Dispositif selon la revendication 7, **caractérisé** en ce que l'unité logique de détection de défaut est réalisée en technique analogique.

9. Dispositif selon la revendication 7, **caractérisé** en ce que l'unité logique de détection de défaut est réalisée en technique numérique.

10. Dispositif selon l'une quelconque des revendications 7 à 9, **caractérisé** en ce qu'un détecteur d'onde directionnel de type connu est adjoint au dispositif de protection à mesure de distance, pour former ainsi ensemble un dispositif de protection de distance.

**Patentansprüche**

1. Verfahren zur Erkennung und Lokalisierung einer Fehlerstelle auf einer Energieübertragungsleitung, die zu einem einphasigen, dreiphasigen oder mehrphasigen Verteilersystem gehört, welches von einem Energienetzwerk mit normaler Netzfreqenz gespeist wird, wobei die Augenblickswerte des Stromes und der Spannung in jeder Phase an den Endpunkten der Übertragungsleitung gemessen werden und die Meßwerte in einem Schieberegister gespeichert werden, **dadurch gekennzeichnet,** daß in einer Anzahl von Kontrollpunkten (1, 2, ...j, ...n) Kontrollspannungen $u_1(t)$, $u_2(t)$, ... $u_j(t)$, ... $u_n(t)$ längs der Übertragungsleitung für jeden Kontrollpunkt in zeitlichen Abständen mittels einer Formel, die aus der Theorie der Wanderwellen abgeleitet ist, berechnet werden gemäß

$$u_j(t) = \frac{D_j}{2}\left[u_O(t-\tau_j) + Zi_O(t-\tau_j)\right] + \frac{1}{2D_j}\left[u_O(t+\tau_j) - Zi_O(t+\tau_j)\right]$$

wobei

$D_j$ = Dämpfungsfaktor der Wanderwelle für den Kontrollpunkt j,

$\tau_j$ = Übertragungszeit der Wanderwelle vom Kontrollpunkt j,

$u_o$ = Spannung im Endpunkt der Übertragungsleitung,

$i_o$ = Strom im Endpunkt der Übertragungsleitung,

Z = Wellenimpedanz,

daß die berechneten Kontrollspannungen längs der Übertragungsleitung und ihrer angenommen Erstreckung über die beiden Endpunkte hinaus zum Erkennen und Lokalisieren einer Fehlerstelle auf der Übertragungsleitung verwendet werden, daß ein Fehler angenommen wird, wenn die Kontrollspannungen in zwei benachbarten Kontrollpunkten fortdauernd unterschiedliche Vorzeichen haben, wobei dieser Fehler zwischen den beiden Punkten auf der Übertragungsleitung liegt, daß die genaue Lokalisierung des Fehlers auf der Übertragungsleitung durch den Punkt der Übertragungsleitung bestimmt wird, in welchem die Kontrollspannung kontinuierlich Null ist, wobei diese Fehlerstelle (f) durch ein Interpolationsverfahren ermittelt wird.

2. Verfahren nach Anspruch 1, **dadurch gekennzeichnet,** daß der Abstand $d_f$ zwischen der Meßstation und dem Fehler nach folgender Formel berechnet wird

$$d_f = d_j + \frac{\delta(k-j)\, u_j}{u_j - u_k}$$

wobei $d_j$ der Abstand zwischen der Meßstation und dem Kontrollpunkt j ist, $\delta(k\text{-}j)$ der Abstand zwischen den Kontrollpunkten k und j ist und $u_j$ und $u_k$ die Kontrollspannungen in den Kontrollpunkten j und k sind.

3. Verfahren nach Anspruch 1, **dadurch gekennzeichnet,** daß bei der Berechnung der Kontrollspannungen Strom- und Spannungswerte verwendet werden, die zu den Zeiten $t + \tau_k$ und $t - \tau_k$ gemessen wurden, wobei $\tau_k$ die von einer Welle benötigte Übertragungszeit auf der Übertragungsleitung vom Meßpunkt zu dem Kontrollpunkt k ist und k die Werte von 0 bis n durchläuft.

4. Verfahren nach einem der vorhergehenden Ansprüche, **dadurch gekennzeichnet,** daß bei dreiphasigen und mehrphasigen Systemen die gemessenen Strom- und Spannungswerte zu unabhängigen Modenwerten transformiert werden, die zur Berechnung der Kontrollspannungen nach der Formel in Anspruch 1 verwendet werden.

5. Verfahren nach einem der vorhergehenden Ansprüche, **dadurch gekennzeichnet,** daß die modenmäßig berechneten Spannungen durch inverse Transformation an ihre entsprechenden ursprünglichen Systeme zurückgegeben werden.

6. Verfahren nach einem der vorhergehenden Ansprüche, **dadurch gekennzeichnet,** daß das Verfahren für den Distanzschutz verwendet wird, wobei die Distanz messende Schutzvorrichtung durch einen richtungsabhängigen Wellendetektor bekannter Art ergänzt wird.

7. Vorrichtung zur Erkennung und Lokalisierung einer Fehlerstelle auf einer Energieübertragungsleitung, die zu einem einphasigen, dreiphasigen oder mehrphasigen Verteilersystem gehört, welches von einem Energienetzwerk mit normaler Netzfreqenz gespeist wird, wobei die Vorrichtung Modentransformationseinheiten (L1, K1), Kontrollspannungsberechner (A2, A3), Schieberegister (S1, S2, S3, S4), inverse Modentransformationseinheiten (K2) und eine Fehlerlogikeinheit (FL) enthält und Zugang zu Strom- und Spannungswerten an den Enden der Übertragungsleitung hat, **dadurch gekennzeichnet,** daß die Modentransformationseinheiten (L1, K1) gemessene Strom- und Spannungswerte in Modenwerte zu transformieren vermögen, daß Einrichtungen vorgesehen sind, um die genannten transformierten Werte aufeinanderfolgend zu den genannten Schieberegistern (S3, S4) zu übertragen und von dort zu den Berechnungseinheiten (A3) zu übertragen zur Berechnung der Kontrollspannungen gemäß der Formel

$$u_j(t) = \frac{D_j}{2}\Big[u_0(t-\tau_j) + Zi_0(t-\tau_j)\Big] + \frac{1}{2D_j}\Big[u_0(t+\tau_j) - Zi_0(t+\tau_j)\Big]$$

wobei
$D_j$ = Dämpfungsfaktor der Wanderwelle für den Kontrollpunkt j,
$\tau_j$ = Übertragungszeit der Wanderwelle vom Kontrollpunkt j,
$u_0$ = Spannung im Endpunkt der Übertragungsleitung,
$i_0$ = Strom im Endpunkt der Übertragungsleitung,
$Z$ = Wellenimpedanz,
daß die Einheiten für die inverse Transformation (K2) die berechneten Kontrollspannungen in die entsprechenden Werte des ursprünglichen Systems zu transformieren vermögen und daß Einrichtungen vorgesehen sind, um diese Werte zu der Fehlerlogikeinheit (FL) zu übertragen zur Bestimmung, ob ein Fehler vorliegt sowie zur Berechnung des Abstandes zwischen dem Fehler und dem Meßpunkt.

8. Verfahren nach Anspruch 7, **dadurch gekennzeichnet,** daß die Fehlerlogikeinheit eine analog arbeitende Einheit ist.

9. Vorrichtung nach Anspruch 7, **dadurch gekennzeichnet,** daß die Fehlerlogikeinheit eine digital arbeitende Einheit ist.

10. Vorrichtung nach einem der Ansprüche 7 bis 9, **dadurch gekennzeichnet,** daß die Distanz messende Schutzvorrichtung durch einen richtungsabhängigen Wellendetektor bekannter Art ergänzt ist, wodurch zusammen eine Distanzschutzvorrichtung gebildet wird.

FIG. 1

FIG. 2

EP 0 164 711 B1

FIG. 3

FIG. 4

FIG. 5

EP 0 164 711 B1

$$u_0'^+ = f(u_0', i_0', Z)$$
$$u_0'^- = f(u_0', i_0', Z)$$

$$L^{-1} = [\ \ ]$$
$$K^{-1} = [\ \ ]$$

$$u_j'(t) = f(D_j, u_0'^+, u_0'^-, t, \tau)$$

$$K = [\ \ ]$$

U_RST  I_RST

L1  A1  S1  S2  A2  K2  FL  K1

TR  $\frac{U}{Z} <$  FR

**FIG. 6**

$$u_0'^+ = f(u_0', i_0', Z)$$
$$u_0'^- = f(u_0', i_0', Z)$$

$$L^{-1} = [\ \ ]$$
$$K^{-1} = [\ \ ]$$

$$u_j'(t) = f(D_j, u_0', i_0', Z, t, \tau)$$

$$K = [\ \ ]$$

U_RST  I_RST

L1  A3  S3  S4  K2  FL  K1

TR  $\frac{U}{Z} <$  FR

**FIG. 7**

FIG. 8